Europäisches Patentamt

European Patent Office

Office européen des brevets

(19)

(11) Publication number: 0 185 097

A1

(12) EUROPEAN PATENT APPLICATION

published in accordance with Art. 158(3) EPC

(21) Application number: 85902654.4

(22) Date of filing: 29.05.85

Data of the international application taken as a basis:

(86) International application number: PCT/JP85/00297

(87) International publication number: WO85/05721 (19.12.85 85/27)

(51) Int. Cl.⁴: G 11 B 11/03
G 11 B 7/26

(30) Priority: 01.06.84 JP 110715/84

(43) Date of publication of application: 25.06.86 Bulletin 86/26

(84) Designated Contracting States: DE FR GB

(71) Applicant: HITACHI, LTD.
6, Kanda Surugadai 4-chome Chiyoda-ku
Tokyo 100(JP)

(72) Inventor: ITO, Masaru
759-15, Aihara Sagamihara-shi
Kanagawa-ken 229(JP)

(72) Inventor: OKAZAKI, Shinji
21-4, Kamikizaki 6-chome
Urawa-shi Saitama-ken 336(JP)

(72) Inventor: TSUNODA, Yoshito
24-12-316, Mure 6-chome
Mitaka-shi Tokyo 181(JP)

(72) Inventor: HARA, Fumio
14-6, Nishi-koigakubo 4-chome
Kokubunji-shi Tokyo 185(JP)

(74) Representative: Patentanwälte Beetz sen. - Beetz jun.
Timpe - Siegfried - Schmitt-Fumian
Steinsdorfstrasse 10
D-8000 München 22(DE)

(54) METHOD OF MANUFACTURING STAMPER.

(57) A method of manufacturing a stamper having a high density and a low reject rate. An organic film formed on the substrate is irradiated with a charged particle beam such as an electron beam or ion beam, in order to form a rugged pattern on the organic film so as to use it as a stamper. Namely, the stamper is directly formed without passing through the steps of forming, first, a mother disc and then forming a stamper from the mother disc. Therefore, the number of steps is reduced and the reject rate is reduced, too, making the method ideal for the manufacture of stampers for high density optical discs.

FIG. 2

(a)

(b)

(c)

(d)

EP 0 185 097 A1

## Technical Field

The present invention relates to a method of producing a stamper for optical disks, and particularly to a method of producing stamper having a high density and a low defect rate.

## Background Art

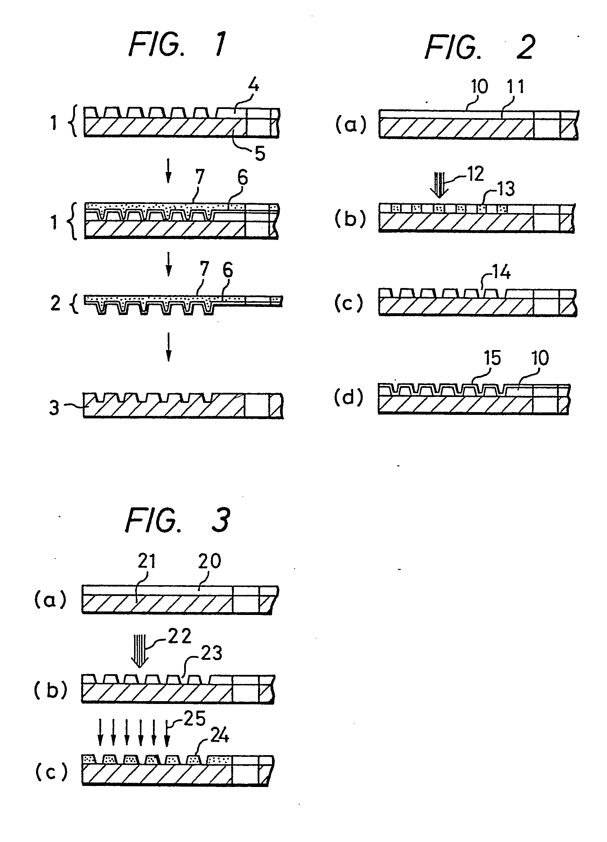

Optical disks such as optical video disks, compact audio disks, and optical memory disks have heretofore been prepared in the order of a master disk 1, a stamper 2, and a replica 3 as shown in Fig. 1. Performance of the optical disks is determined by the shape of pits or grooves formed on the disk to produce signals, and extraneous rough patterns that do not contribute to signals, i.e., the size of defects and the number of defects. Their shapes are almost determined in the processes of forming the master disk and stamper. In these processes, therefore, it is necessary to form the pits or grooves in accordance with the specified shapes while suppressing the defect rate as small as possible.

According to a conventional method as shown in Fig. 1, pits or grooves for producing signals are formed in the master disk by the photo-lithography using a laser beam, rugged patterns of photoresist 4 on a glass plate 5 are transferred to an electrically conductive layer 6 or a nickel plating 7 that will be used as a stamper 2. Or, using the stamper 2 as a master, the patterns are transferred again to the electrically conductive layer or the nickel plating as described above to use it as a mother. Relying upon the thus obtained mother, the patterns are transferred to the electrically conductive layer or the nickel plating for the third time, thereby to form a stamper (metal mold). This presents an advantage that large numbers of the same replicas can be produced at the saem time, since plural mothers are formed. Using the stampers, there are produced a large number of replicas 3 by injection molding, pressing, or by using an ultraviolet curable resin (for example, refer to Japanese Patent Laid-Open No. 116105/1978).

The master disk is formed by photo-lithography, and nickel is plated thereon. In other words, the processes for forming the master disk and the stamper are so lengthy and complex, that dust and dirt often stick to the master disk and the stamper during these processes, and that makes it difficult to prevent defects from occurring. Rough patterns of signals become more fine with the increase of the density of recorded data, and whereby the problem of defects become more serious.  Therefore, it has become urgent to provide a process which lowers the defect rate.

Disclosure of Invention

The object of the present invention is to provide a method of producing stamper having a low defect rate.

To achieve the above object according to the present invention, an organic layer formed on a substrate is irradiated with a beam of charged particles, such as electron beam or ion beam, to form rough patterns on the organic layer so as to use it as a stamper.  According to the present invention, the stamper is formed directly without passing through the steps of preparing, first, the master disk and then forming the stamper from the master disk.  Namely, the production steps are simplified to limit the development of defects.

The stamper must have durability to produce replicas in large numbers.  With the stamper of the present invention, the organic layer formed on the substrate is cured with an ion beam to increase durability, or a metal layer is formed by sputtering on the surface of the organic layer and of the substrate to further increase durability.

Brief Description of Drawings

Fig. 1 is a schematic diagram showing a conventional method of producing an optical disk;

Figs. 2 and 3 are diagrams showing embodiments according to the present invention;

Fig. 4 is a schematic diagram showing an apparatus for producing stamper according to the present invention; and

Fig. 5 is a diagram showing the preparation of a replica using the stamper obtained according to the present invention.

Best Mode for Carrying Out the Invention

The invention will be described below by way of embodiments. Fig. 2 shows an embodiment of the present invention. Referring to Fig. 2(a), first, an electron beam resist 10 such as PMMA-AN (polymethyl methacrylate-acrylonitrile) is applied onto a substrate 11 which consists of a glass, silicon or a metal. The surface of the substrate may have been treated; for example, a primer coating may have been applied onto the surface of the substrate to maintain adhesiveness to the resist. In Fig. 2(b), the rotating stamper is irradiated with an electron beam 12 at a predetermined position, so that raised, bonded molecules of the resist are cut to form a latent image 13. The substrate is heated at, for example, 150°C to 180°C for 30 minutes. The resist portions 13 where the bond cut off to acquire a low molecular weight, evaporate, resulting in the formation of pits as denoted by 14 in Fig. 2(c). The substrate under this condition can be used as the stamper. As shown in Fig. 2(d), furthermore, a metal 15 such as nickel is deposited by sputtering on the resist 10, to obtain the stamper that exhibits increased durability. According to this method, rough patterns can be continuously formed on the resist using an electron-beam drawing apparatus in a vacuum without permitting the infiltration of dust or dirt, thereby enabling the defect rate to be greatly reduced.

Fig. 3 shows another embodiment of the present invention. Referring to Fig. 3(a), an organic layer 20 is applied or vaporized onto a substrate 21. The organic layer may be a photosensitive resin such as resist, or may be a non-photosensitive resin such as epoxy resin. Next, as shown in Fig. 3(b), the surface is irradiated with an ion beam 22 according to a predetermined pattern. The ion beam may be argon ions. Then, due to the reaction with ions, etching takes place on the irradiated portions to form pits 23, thereby forming a predetermined rough pattern. Then, the surface is uniformly irradiated with a different kind of ion beam such as boron ions, phosphorus ions, gallium ions or like ions as shown in Fig. 3(c) to cure (carbonize) the organic layer. Thus, there is obtained a stamper having durability.

In the embodiment shown in Fig. 2, after the rough pattern is formed in the resist portion by the electron beam (i.e., after the step of Fig. 2(c)), the organic layer may be irradiated with the beam of phosphorus ions so as to be cured. It is further allowable to irradiate the organic layer with the ion beam to cure it (step of Fig. 3(c)) and then to deposite a metal film by sputtering on the surface of rugged portions, in order to increase the strength of the stamper.

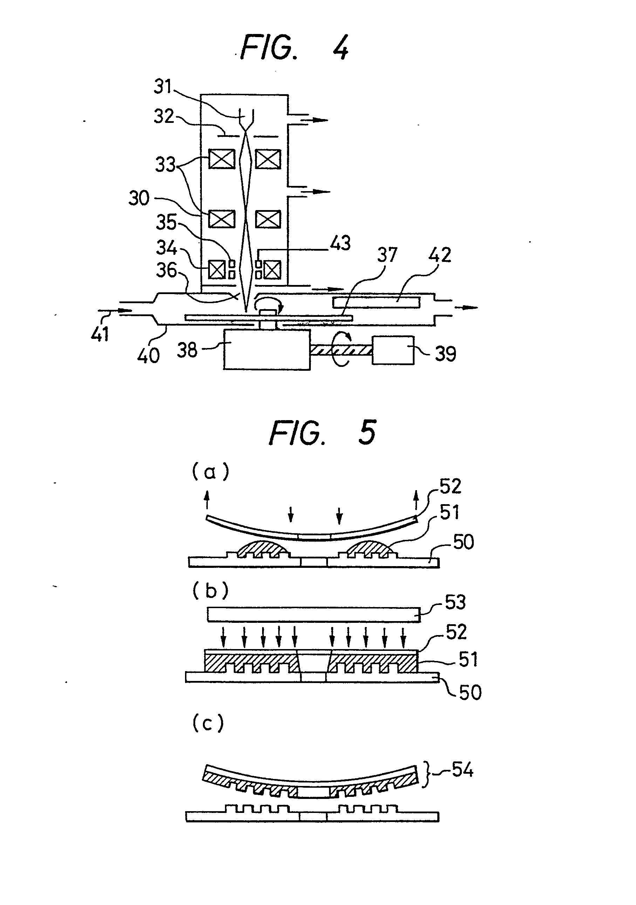

Fig. 4 schematically shows an apparatus for producing a stamper for putting the invention into practice, wherein reference numeral 30 denotes a charged beam focusing system, 36 denotes a differential exhaust system, and 40 denotes an oven-sputter chamber. The charged beam emitted from a charge beam source 31 is accelerated by an anode 32, and is focused on a disk 37 that is to be worked through condenser lenses 33, a deflecting lens 34 and an object glass 35. The electron beam is deflected by a deflection signal 43 to control the position of rugged portion. The disk moves helically relative to the charged beam being driven by a motor 38 and a feed motor 39 like in the conventional mastering machine for optical disk. In the apparatus for producing a stamper for putting the present invention into practice, in particular, use is made of the differential exhaust system 36 having layers of different degrees of vacuum. Therefore, the system for rotating the disk can be operated in the open air. This is because, the differential exhaust system can change the degree of vacuum between the charged beam focusing system 30 and the oven-sputter chamber 40. Hence, a pneumatic bearing can be used.

The disk is placed in the oven-sputter chamber 40 and is heated by blowing a clean gas 41 at a high temperature to evaporate the portions irradiated with the charged beam. After the irradiation has been finished, the disk is moved to a place under a sputtering electrode 42 where the disk is rotated and is provided with a layer such as nickel by sputtering. The metal film may be formed by vapor deposition instead of sputtering. In this case, the interior of the chamber 40 is evacuated as a matter of course. Though not shown in the drawings, the differential exhaust is also applied to the spindle portion of disk 37.

In Fig. 4, irradiation of the charged beam and the sputtering are effected in the same apparatus. They, however, may be effected in separate apparatuses.

Fig. 5 shows a method of producing replica from the stamper obtained according to the present invention. The stamper obtained by the invention has a surface which is softer than that of the conventional nickel-cast stamper, and can suitably be prepared by using an ultraviolet curable resin or by the casting rather than the pressing or the injection molding. Fig. 5 shows the method of using an ultraviolet curable resin. In Fig. 5(a), an ultraviolet curable resin 51 is placed on a stamper 50. Then, a substrate 52 made of a glass or a light-transmitting resin of which the surface has been treated with a primer, is pressed onto the resin 51 on the stamper 50, the substrate 52 being formed into a cup shape by depressing the central portion thereof and drawing the peripheral portion thereof. With the substrate 52 pushed being curved like a cup, the resin is uniformly formed on the surface of the glass or the resin. Referring to Fig. 5(b) where the resin 51 is spread maintaining a uniform thickness between the substrate 52 and the stamper 50, ultraviolet rays are applied by an ultraviolet lamp 53 from the side of the substrate to cure the resin. Then, the resin which is hardened is pulled off to obtain a replica 54 as shown in Fig. 5(c).

Industrial Applicability

According to the present invention as described above, the stamper can be formed directly enabling the production steps to be simplified and the defect rate to be reduced. Further, since use is made of a beam of charged particles such as electron beam or ion beam, the patterns can be formed more finely than those formed by the conventional method of using a laser beam. This is because, the electron beam can be converged more finely than the light beam. Moreover, since the time required for the manufacturing steps is shortened, the time can be greatly shortened to produce the optical disk, to evaluate the signals produced by the optical disk, and to determine the processing conditions. Accordingly, the productivity can be increased.

Thus, the present invention can be effectively adapted to a method of producing a stamper for optical disks.

WHAT IS CLAIMED IS:

1. A method of producing a stamper by irradiating an organic layer formed on a substrate with a beam of charged particles, to form a rough pattern on said organic layer.

2. A method of producing a stamper according to claim 1, wherein said beam of charged particles is an electron beam.

3. A method of producing a stamper according to claim 2, wherein said organic layer is irradiated with said electron beam under the heated condition, to form a rugged pattern on said organic layer.

4. A method of producing a stamper according to claim 3, wherein said organic layer is composed of a polymethyl methacrylate-acrylonitrile.

5. A method of producing a stamper according to claim 2, wherein the surface of the rough pattern of said organic layer is further irradiated with an ion beam to cure said organic layer.

6. A method of producing a stamper according to claim 2, wherein a metal layer is formed by sputtering on the surface of rugged pattern of said organic layer.

7. A method of producing a stamper according to claim 1, wherein said beam of charged particles is an ion beam.

8. A method of producing a stamper according to claim 7, wherein the surface of rugged pattern of said organic layer is further irradiated with an ion beam to cure said organic layer.

9.    A method of producing a stamper according to claim 7, wherein a metal layer is formed by sputtering on the surface of rough pattern of said organic layer.

0185097

## FIG. 1

$1\{$ ... 4, 5

↓

$1\{$ ... 7, 6

↓

$2\{$ ... 7, 6

↓

3 ...

## FIG. 2

(a) 10, 11

↓ 12

(b) 13

(c) 14

(d) 15, 10

## FIG. 3

(a) 21, 20

↓ 22

(b) 23

↓ 25, 24

(c)

0185097

## FIG. 4

31
32
33
30
35
34
36
43
37
42
41
40
38
39

## FIG. 5

(a)
52
51
50

(b)
53
52
51
50

(c)
54

# INTERNATIONAL SEARCH REPORT

International Application No. PCT/JP85085097

## I. CLASSIFICATION OF SUBJECT MATTER (if several classification symbols apply, indicate all) ³

According to International Patent Classification (IPC) or to both National Classification and IPC

Int. Cl⁴ G11B11/03, G11B7/26

## II. FIELDS SEARCHED

### Minimum Documentation Searched ⁴

| Classification System | Classification Symbols |
|---|---|
| IPC | G11B7/26, 9/10, 11/00, 11/03, 11/12 |

### Documentation Searched other than Minimum Documentation to the Extent that such Documents are Included in the Fields Searched ⁵

| | |
|---|---|
| Jitsuyo Shinan Koho | 1955 – 1985 |
| Kokai Jitsuyo Shinan Koho | 1971 – 1985 |

## III. DOCUMENTS CONSIDERED TO BE RELEVANT ¹⁴

| Category* | Citation of Document, ¹⁶ with indication, where appropriate, of the relevant passages ¹⁷ | Relevant to Claim No. ¹⁸ |
|---|---|---|
| X | JP, A, 49-18319 (RCA Corporation) 18 February 1974 (18. 02. 74) & US, A, 3943302 & FR, A, 2181035 | 1, 2 |
| X | JP, A, 57-82237 (Nippon Telegraph & Telephone Public Corporation) 22 May 1982 (22. 05. 82) (Family : none) | 1, 2, 4 |
| X | JP, A, 58-35742 (Victor Company of Japan, Limited) 2 March 1983 (02. 03. 83) (Family : none) | 1, 2, 6 |
| Y | JP, A, 57-66547 (Toshiba Corporation) 22 April 1982 (22. 04. 82) P. 2, lower right column, line 18 to P. 3, upper left column, line 13 (Family : none) | 6, 9 |
| Y | JP, A, 58-222453 (Fuji Photo Film Co., Ltd.) 24 December 1983 (24. 12. 83) (Family : none) | 7 |
| A | JP, A, 58-222453 (Fuji Photo Film Co., Ltd.) 24 December 1983 (24. 12. 83) (Family : none) | 5, 8 |

* Special categories of cited documents: ¹⁵

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance: the claimed invention cannot be considered novel or cannot be considered to involve an inventive step

"Y" document of particular relevance: the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search ² | Date of Mailing of this International Search Report ³ |
|---|---|
| August 21, 1985 (21. 08. 85) | September 2, 1985 (02. 09. 85) |
| International Searching Authority ¹ | Signature of Authorized Officer ²⁰ |
| Japanese Patent Office | |

Form PCT/ISA/210 (second sheet) (October 1981)

| A | JP, A, 57-66547 (Toshiba Corporation) 22 April 1982 (22. 04. 82) P.2, lower right column, lines 12 to 17, (Family : none) | 0185097 5, 8 |

## V. ☐ OBSERVATIONS WHERE CERTAIN CLAIMS WERE FOUND UNSEARCHABLE [10]

This international search report has not been established in respect of certain claims under Article 17(2) (a) for the following reasons:

1. ☐ Claim numbers_____, because they relate to subject matter [12] not required to be searched by this Authority, namely:

2. ☐ Claim numbers_____, because they relate to parts of the international application that do not comply with the prescribed requirements to such an extent that no meaningful international search can be carried out [13], specifically:

## VI. ☐ OBSERVATIONS WHERE UNITY OF INVENTION IS LACKING [11]

This International Searching Authority found multiple inventions in this international application as follows:

1. ☐ As all required additional search fees were timely paid by the applicant, this international search report covers all searchable claims of the international application.

2. ☐ As only some of the required additional search fees were timely paid by the applicant, this international search report covers only those claims of the international application for which fees were paid, specifically claims:

3. ☐ No required additional search fees were timely paid by the applicant. Consequently, this international search report is restricted to the invention first mentioned in the claims; it is covered by claim numbers:

4. ☐ As all searchable claims could be searched without effort justifying an additional fee, the International Searching Authority did not invite payment of any additional fee.

Remark on Protest

☐ The additional search fees were accompanied by applicant's protest.

☐ No protest accompanied the payment of additional search fees.